(19) **Europäisches Patentamt European Patent Office Office européen des brevets**

(11) **EP 2 354 799 B1**

(12) **FASCICULE DE BREVET EUROPEEN**

(45) Date de publication et mention de la délivrance du brevet:
**05.04.2017 Bulletin 2017/14**

(51) Int Cl.:
*G01R 15/26* (2006.01)      *G01R 19/252* (2006.01)
*G01R 22/06* (2006.01)

(21) Numéro de dépôt: **11354001.7**

(22) Date de dépôt: **17.01.2011**

(54) **Dispositif et procédé de comptage d'énergie électrique**

Einrichtung und Verfahren zum Zählen elektrischer Energie

Device and method for metering electric energy

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.02.2010 FR 1000504**

(43) Date de publication de la demande:
**10.08.2011 Bulletin 2011/32**

(73) Titulaire: **Schneider Electric Industries SAS 92500 Rueil-Malmaison (FR)**

(72) Inventeurs:
 • **Coutelou, Olivier**
   **38050 Grenoble Cedex 09 (FR)**
 • **Lebeau, Bernard**
   **38050 Grenoble Cedex 09 (FR)**
 • **Paupert, Marc**
   **38050 Grenoble Cedex 09 (FR)**

(74) Mandataire: **Tripodi, Paul et al Schneider Electric Industries SAS Service Propriété Industrielle World Trade Center / 38EE1 5 Place Robert Schuman 38050 Grenoble Cedex 09 (FR)**

(56) Documents cités:
 JP-A- 2 042 367      JP-A- 56 063 264
 JP-U- 56 029 471     US-A- 3 460 042
 US-A1- 2009 309 754

**Description**

**DOMAINE TECHNIQUE**

L'invention concerne un dispositif de comptage d'énergie électrique comportant :

- au moins un capteur de courant pour fournir un courant secondaire de mesure représentatif d'un courant primaire circulant dans un conducteur électrique primaire,
- un circuit électronique de mesure et de redressement connecté audit au moins un capteur de courant,
- un circuit de traitement connecté au circuit électronique de mesure et de redressement, et
- un émetteur connecté au circuit de traitement pour émettre des messages dans un réseau de communication sans fils vers un récepteur de mesure d'énergie électrique.

L'invention concerne aussi un procédé de comptage d'énergie électrique.

**ETAT DE LA TECHNIQUE**

Les dispositifs de comptage d'énergie électrique électroniques à éléments déportés sont disposés sur des conducteurs de lignes électriques pour estimer ou mesurer le courant la puissance et/ou l'énergie électrique. Les systèmes dits sans fils ont généralement une première partie sur le conducteur électrique avec un émetteur radio et une seconde partie centralisatrice avec un récepteur radio et un traitement centralisé de la puissance et de l'énergie électrique.

La demande de brevet WO2008142429 montre un premier exemple de dispositif connu. La tension du réseau et mesurée en local avec un diviseur capacitif.

L'alimentation des circuits électroniques est basée essentiellement sur la présence d'une batterie.

Le document EP2048482 décrit une alimentation des circuits électroniques avec des sources multiples et une batterie.

Les documents JP56063264, JP2042367 et JP56029471 décrivent des dispositifs autonomes à commande de diodes électroluminescentes. Cependant, ces dispositifs donnent des indications vagues de fonctionnement et ne permettent pas une mesure suffisamment précise du courant circulant dans les lignes ni des mesures de puissance satisfaisantes.

Les dispositifs de l'état de la technique sont généralement tributaires d'une alimentation externe ou de la présence d'une pile ou d'une batterie rechargeables. Ils disposent ainsi d'une autonomie relative et ne permettent pas d'être opérationnels à tous moment.

**EXPOSE DE L'INVENTION**

L'invention a pour but un dispositif et un procédé de comptage d'énergie électrique permettant d'éviter l'usage de source d'énergie externe, de piles ou de batteries rechargeables.

Un dispositif de comptage d'énergie électrique selon l'invention est défini dans la revendication 1.

De préférence, lesdits moyens interrupteurs sont composés d'un composant de type thyristor arrêtant de conduire au dessous d'un courant de maintien, et lesdits moyens de détection sont dans un composant à référence de tension à faible courant de fuite en entrée.

Dans un mode de réalisation préférentiel, le dispositif comporte des moyens de décharge pour décharger ledit condensateur d'intégration en fin de cycle d'émission.

Avantageusement, lesdits messages d'énergie émis par l'émetteur comportent des données de comptage d'impulsions.

De préférence, lesdits messages d'énergie émis par l'émetteur comportent des données de comptage d'énergie ou de comptage de quantité de courant.

Dans un mode de réalisation particulier, le dispositif comporte des moyens de détection d'un passage à zéro du courant, ledit message d'énergie étant émis lorsqu'un passage à zéro est détecté.

Avantageusement, le circuit de traitement comporte des moyens de correction pour corriger localement des valeurs des données d'énergie en fonction de paramètres pré-chargés ou envoyés par des messages précédents en retour. Avantageusement, le dispositif comporte des moyens de calcul d'une valeur moyenne dudit courant primaire disposés dans ledit circuit de traitement et/ou dans un module de traitement d'un récepteur.

Un procédé de comptage d'énergie électrique selon l'invention est défini dans la revendication 6.

Avantageusement, le procédé de comptage comporte :

- la réception dudit message représentatif d'une quantité d'énergie électrique par un récepteur, et
- l'incrémentation d'un compteur d'énergie électrique.

Avantageusement, le procédé de comptage comporte :

- la réception d'un message de retour depuis un récepteur comportant des valeurs de correction et de paramétrage, et
- l'élaboration et l'émission dudit message d'énergie représentatif d'une quantité d'énergie électrique avec des données complètes de valeur d'énergie électrique. Dans un mode de réalisation particulier, le procédé de comptage comporte :
- l'attente d'un passage à zéro dudit courant secondaire pour émettre ledit message représentatif d'une quantité d'énergie électrique,
- la détection d'un instant de passage à zéro d'une tension électrique par un récepteur, et
- la détermination par ledit récepteur d'une valeur représentative d'un déphasage entre une tension et un courant en fonction de l'instant de passage à zéro de la dite tension électrique et de l'instant de réception dudit message d'énergie.

Avantageusement, l'émission des messages d'énergie est effectuée lorsqu'un nombre prédéterminé de cycles de charges et décharges dudit condensateur est réalisé, la valeur de d'énergie électrique à émettre dépendant dudit nombre prédéterminé de cycles.

De préférence, le procédé de comptage comporte la correction de valeurs ou de quantités d'énergie électrique pour corriger une non linéarité dudit capteur de courant sur la plage de fonctionnement, des erreurs dues à des courant de fuite de composant et/ou des erreurs dues à des temps de traitement et de transmission.

De préférence, le procédé de comptage comporte l'émission d'un message en retour depuis un récepteur de message d'énergie, ledit message de retour comportant des données représentatives d'un déphasage entre une tension et un courant, d'une valeur de tension électrique, d'un nombre de cycles de charge-décharge avant émission de message, de paramètres de correction et/ou une valeur d'énergie électrique corrigée.

**BREVE DESCRIPTION DES DESSINS**

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :

- la figure 1 représente un dispositif de comptage d'énergie électrique avec une liaison sans fils selon un mode réalisation de l'invention ;
- la figure 2 représente un schéma d'un dispositif selon un premier mode de réalisation de l'invention ;
- la figure 3 représente un schéma d'un dispositif selon un second mode de réalisation de l'invention ;
- les figures 4A et 4B représentent des chronogrammes de charges et décharges de condensateurs dans des dispositifs selon des modes de réalisation de l'invention ;
- les figures 5A et 5B représentent des contenus de messages émis dans des dispositifs selon des modes de réalisation de l'invention ;
- les figures 6A à 6D illustrent un premier fonctionnement d'un dispositif selon un mode de réalisation de l'invention ;
- les figures 7A à 7C illustrent un second fonctionnement d'un dispositif selon un mode de réalisation de l'invention ;
- la figure 8 représente un schéma bloc d'un récepteur de message selon un dispositif d'un mode de réalisation de l'invention ;
- les figures 9 et 10 représentent un premier organigramme d'un procédé selon un mode de réalisation de l'invention ; et
- la figure 11 représente un second organigramme d'un procédé complémentaire selon un mode réalisation de l'invention.

**DESCRIPTION DETAILLEE DE MODES DE REALISATION PREFERES**

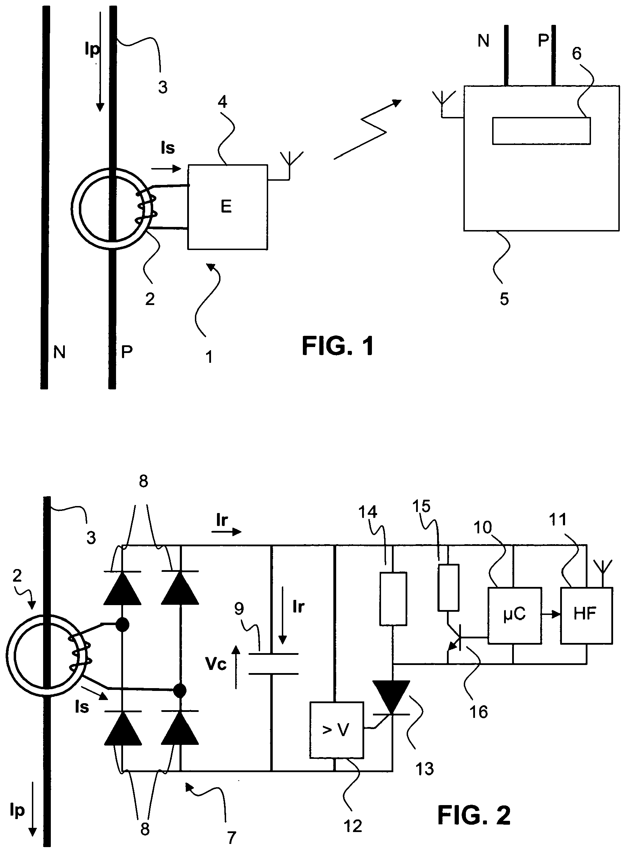

La figure 1 représente un dispositif de comptage d'énergie électrique avec une liaison sans fils pour émettre des impulsions représentatives d'une quantité d'énergie électrique prédéfinie. Le dispositif comporte une partie émetteur 1 avec un capteur de courant 2 pour fournir un courant secondaire de mesure Is représentatif d'un courant primaire Ip circulant dans un conducteur électrique primaire 3. Le courant Is est traité par un module électronique 4 pour émettre des messages radio représentatifs d'une quantité d'énergie électrique. L'énergie électrique est réalisée par intégration du courant sachant que par ailleurs, la tension du réseau est estimée ou mesurée par d'autres moyens. Lorsqu'une quantité d'énergie est atteinte, une impulsion sous forme de message est envoyée à un récepteur 5 disposé à distance. Le récepteur reçoit les messages et traite les informations d'énergie notamment par un stockage et un affichage des valeurs sur un écran 6.

La figure 2 représente un schéma d'un dispositif selon un premier mode de réalisation de l'invention. Le capteur de courant 2 fournit le courant secondaire de mesure Is représentatif du courant primaire Ip à un circuit électronique de mesure et de redressement. Ainsi le capteur est connecté à un pont redresseur 7 de quatre diodes 8. En sortie du pont redresseur, un courant redressé Ir est appliqué à un condensateur 9 d'intégration du courant Ir. Dans ce cas, le condensateur d'intégration de courant électrique est connecté au capteur de courant à travers des moyens de redressement de courant. Une tension Vc aux bornes du condensateur est représentative de l'intégration du courant dans le temps et par conséquent d'une énergie électrique puisque la tension V du réseau est connue et constante ainsi que le déphasage ou le facteur de puissance. Ce dispositif comporte aussi un circuit de traitement connecté au circuit électronique de mesure et de redressement et un émetteur connecté au circuit de traitement 10 pour émettre des messages dans un réseau de communication sans fils vers le récepteur 5 de mesure d'énergie électrique. Le dispositif fonctionne en deux temps. Dans un premier temps il y a intégration ou accumulation du courant Ir dans le condensateur 9 pour donner une tension représentative d'une quantité d'énergie électrique. Puis, dans un deuxième temps, l'émission d'un message est déclenchée lorsque la quantité d'énergie atteint un niveau prédéterminé.

Dans ce mode de réalisation de l'invention le dispositif comporte un détecteur 12 à seuil de tension connecté au condensateur 9 pour détecter le dépassement d'une tension prédéterminé sur le condensateur d'intégration 9. Un interrupteur 13 commandé par le détecteur à seuil 12 déclenche l'alimentation électrique du circuit de traitement 10 et de l'émetteur 11 avec l'énergie accumulée dans le condensateur lorsque la tension électrique sur le condensateur d'intégration a dépassé ledit seuil de tension prédéterminé. A ce moment, le circuit de traitement 10 et l'émetteur 11 émettent un message d'énergie représentatif d'une quantité d'énergie électrique ou d'une intégration de courant ayant circulé dans ledit conducteur électrique primaire. L'interrupteur 13 est avantageusement un composant de type thyristor arrêtant de conduire automatiquement au dessous d'un courant de maintien. Ce composant de type thyristor peut être aussi remplacé par des montages à transistors ayant des caractéristiques semblables avec commande par entrée ou électrode gâchette et arrêt de la conduction par diminution du courant traversant. Le détecteur 12 à seuil de tension est de préférence un composant à référence de tension à faible courant de fuite d'entrée afin de limiter des fuites de courant pendant la charge du condensateur. Une résistance 14 en parallèle avec l'alimentation des circuits 10 et 11 permet de faire circuler un courant minimal pour garantir la conduction dudit thyristor 13.

Dans le second temps de fonctionnement, le traitement et l'émission d'un message doit se faire rapidement. La durée de ce processus doit être très inférieure à la durée d'une charge de condensateur, elle est de préférence connue et calibrée. A la fin de ce second temps, la décharge du condensateur doit être rapide pour repartir sur un nouveau cycle. Ainsi, le dispositif comporte un circuit de décharge rapide pour vider la charge du condensateur en fin de cycle d'émission. Ce circuit de décharge rapide comporte une résistance 15 de faible valeur en série avec un transistor 16 commandé par le circuit de traitement 10 en fin de cycle. Lorsque le condensateur est déchargé, le courant du thyristor devient bas ou proche de zéro puis le thyristor se bloque naturellement. Les circuits électroniques en aval du condensateur 9 ne sont plus alimentés et la charge du condensateur 9 peut recommencer.

L'énergie sur charge résistive sans déphasage peut être exprimée par une intégrale d'un produit entre une tension V et un courant I.

$$ E = \int V(t)\, I(t)\, dt $$

Puisque la tension est supposée constante au moins pendant un intervalle de temps entre deux messages, l'énergie peut s'exprimer le la façon suivante :

$$ E = V \int I(t)\, dt $$

L'énergie E et la tension V sont déterminées dans un récepteur par conséquent une partie dite émetteur fournira l'intégration de I :

$$ \int I(t)\, dt $$

Où dt est déterminé par un intervalle temps entre deux messages. La tension Vc sur le condensateur d'intégration et représentative de l'intégrale de courant. Lorsqu'un message est émis, il est donc représentatif d'une quantité d'énergie. Cette valeur peut servir aussi à déterminer une valeur moyenne du courant primaire.

L'intégration de I est aussi représentative d'une quantité de courant électrique ayant circulé dans ledit conducteur électrique primaire Ip: Ainsi, des moyens de calcul peuvent être disposés dans le circuit de traitement 10 et/ou dans un module de traitement d'un récepteur pour calculer une valeur moyenne dudit courant primaire Ip.

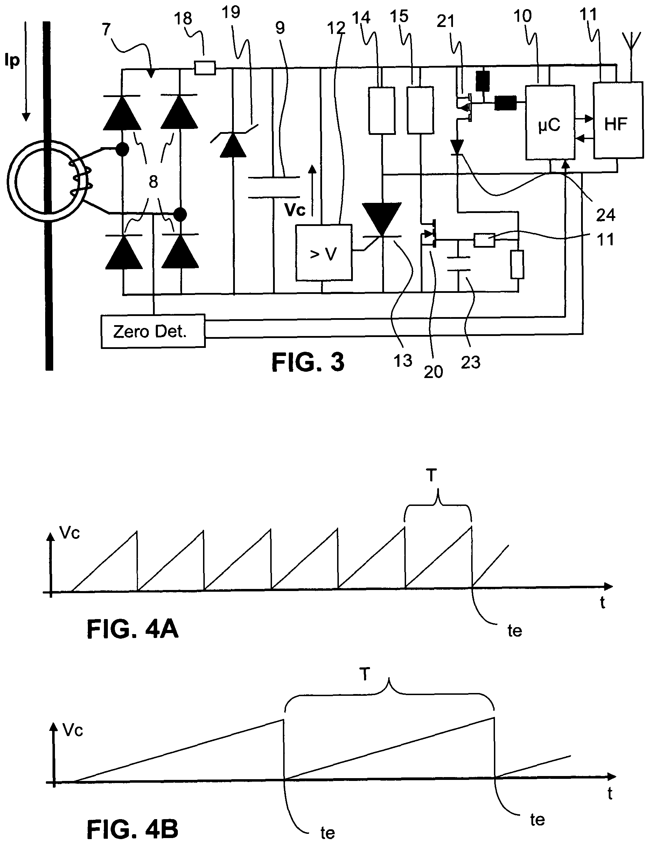

La figure 3 représente un schéma d'un dispositif selon un second mode de réalisation de l'invention. Dans ce mode de réalisation, le circuit de traitement 10 et l'émetteur 11 peuvent fonctionner de manière bidirectionnelle. Le dispositif comporte aussi un détecteur 17 de passage à zéro du courant connecté par exemple entre une entrée du pont redresseur 7 et une entrée du circuit de traitement 10. Dans ce cas, l'émission dudit message d'énergie est retardée jusqu'à la détection d'un passage à zéro. Cette attente permettra à un récepteur de calculer un délai entre un passage à zéro d'une tension alternative du réseau et le passage à zéro du courant représenté par la réception dudit message d'énergie. Le délai entre les passages à zéro est utilisé notamment pour un calcul d'un déphasage φ entre le courant et la tension et/ou un facteur de puissance ou le cosinus φ d'une installation.

La figure 3 montre aussi un circuit de protection composée d'une résistance 18 et d'une diode 19 de protection contre les surtensions. Ce circuit évite que des perturbations qui se propagent sur le conducteur 3 du réseau perturbent le fonctionnement du dispositif. La résistance 18 est de faible valeur pour ne pas perturber l'impédance globale du circuit et la diode 19 sera choisie parmi celles qui ont un très faible courant de fuite pour éviter toutes dérivations du courant Ir pendant la charge du condensateur 9. Sur ce schéma, le circuit de décharge rapide comporte une résistance 15 et un transistor 20 connecté directement en parallèle sur le condensateur 9 pour vider complètement le condensateur sans supporter une tension directe du thyristor ou un arrêt de sa conduction à faible courant. Pour être compatible avec différentes lignes de référence, un transistor 21 référencé à une ligne positive commande le transistor 20 une diode anti retour 24. Un circuit retardateur composé d'une résistance 22 et d'un condensateur 23 continue à commander le transistor 20 de décharge pendant un court instant même si le circuit 10 n'est plus alimenté.

Les figures 4A et 4B représentent des chronogrammes de charges et décharges du condensateur 9 dans des dispositifs selon des modes de réalisation de l'invention. Sur la figure 4A le courant est élevé et une période T de charge et décharge est courte. Sur la figure 4B le courant est plus faible est la période T est plus longue. Aux instants te un message représentatif d'une unité d'énergie est envoyé. Ces messages peuvent être envoyés à chaque fin de charge du condensateur ou selon un nombre N de charges prédéterminé pour éviter un nombre de messages trop importants lorsque le courant est fort et les charges du condensateur très fréquentes. La réduction du nombre de messages réduit aussi la densité de messages dans le réseau de communication.

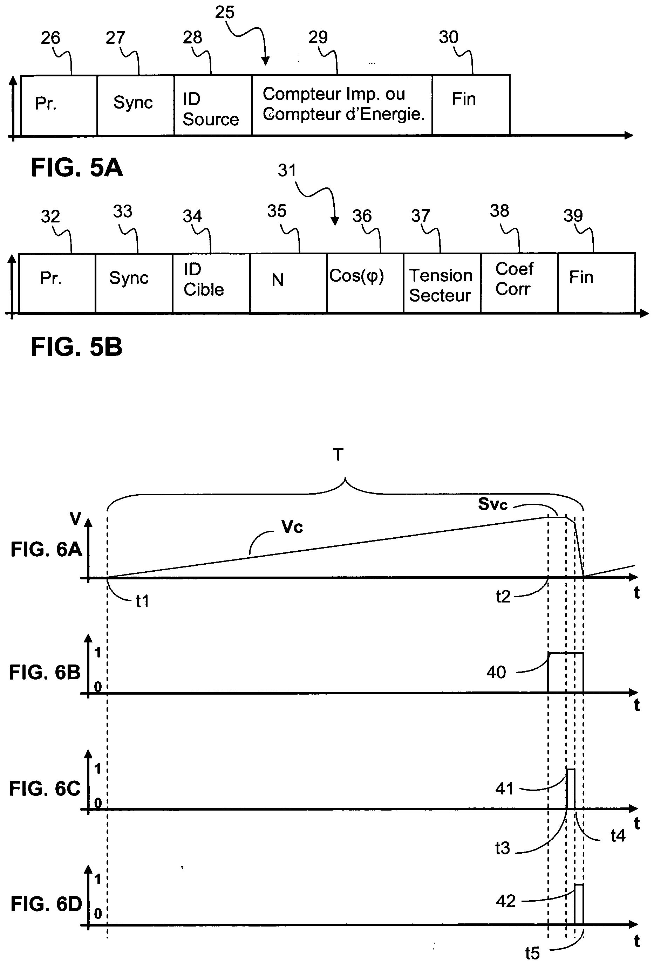

Les figures 5A et 5B représentent des contenus de messages émis et/ou reçus dans des dispositifs selon des modes de réalisation de l'invention. Sur la figure 5A, un premier message 25 émis comporte un préambule 26, un donnée de synchronisation 27, un identifiant 28 de l'émetteur et/ou de la source, une information 29 représentative de l'énergie, et une donnée 30 de fin d'émission ou de contrôle. L'information 29 peut être une valeur fixe associée notamment à des données de comptage d'impulsions, une valeur variable incrémentée à chaque impulsion ou émission, une valeur variable associée à un nombre N de cycle de charge, ou une valeur de cumul d'énergie électrique. Ainsi les messages d'énergie émis par l'émetteur comportent des données de comptage d'impulsions et/ou des données de comptage d'énergie.

Sur la figure 5B un second message 31 est reçu en retour depuis un récepteur. Un tel message est utilisé notamment pour le paramétrage du circuit de traitement et de l'émetteur. Le message 31 de retour comporte un préambule 32, un donnée de synchronisation 33, un identifiant 34 de la cible ou du récepteur, une donnée 35 pour le nombre N d'attente de charges entre des émissions, un déphasage ou un facteur de puissance 36 déterminé par le récepteur, une valeur 37 de tension du réseau, un ou plusieurs coefficients correcteurs 38 de l'énergie, et/ou une donnée 39 de fin d'émission ou de contrôle. Dans ce cas, le circuit de traitement comporte des moyens de correction pour corriger localement des valeurs des données d'énergie en fonction de paramètres pré-chargés ou envoyés par des messages précédents en retour.

Les figures 6A à 6D illustrent un premier fonctionnement d'un dispositif selon un mode de réalisation de l'invention. Sur la figure 6A une courbe Vc représente la tension de charge du condensateur 9. A l'instant t1 le condensateur commence à se charger avec le courant Ir redressé du capteur, puis à l'instant t2 un seuil Svc de charge est atteint. L'interrupteur 13 devient conducteur, représenté par une courbe d'état 40 de la figure 6B, et commande l'alimentation des circuits de traitement et d'émission. Sur la figure 6C, une courbe 41 montre l'émission d'un message d'énergie entre des instants t3 et t4. Puis une courbe 42 de la figure 6D montre la commande de décharge du condensateur entre l'instant t4 et un instant t5 de décharge complète.

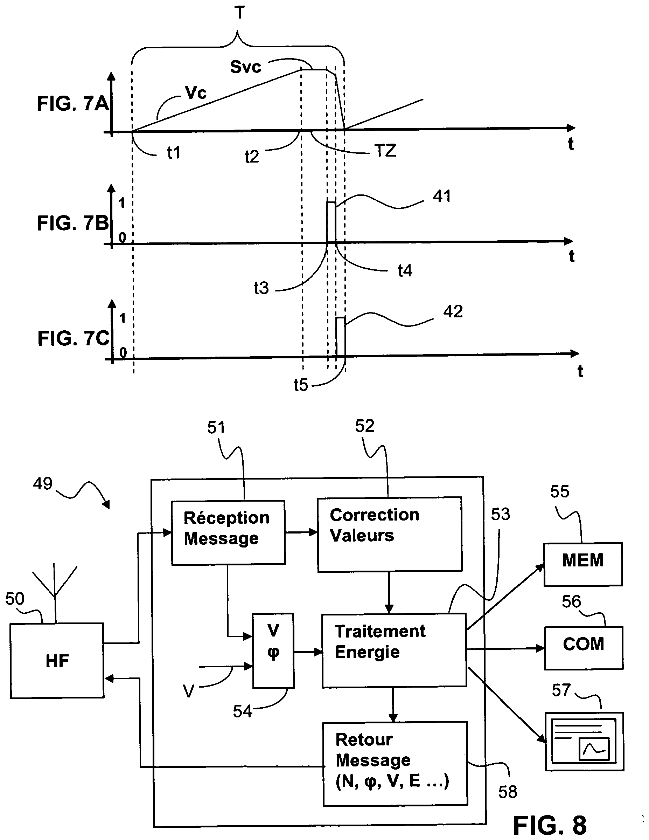

Les figures 7A, 7B et 7C illustrent respectivement la courbe Vc de tension de charge du condensateur 9, la courbe 41 d'émission de message, et la courbe 42 de commande de décharge du condensateur 9. Après l'instant t2 de dépassement de seuil et de commande d'alimentation des circuits, le circuit de traitement attend un prochain passage à zéro pour déclencher l'émission de message d'énergie. Sur la figure 7A, l'attente se fait pendant une période Tz. Un tel retard permet de synchroniser l'émission de message avec un passage à zéro et de permettre ainsi à un récepteur de calculer un décalage entre un passage à zéro d'une tension de secteur et un courant. Un tel décalage de temps entre le courant et la tension peut servir à calculer un déphasage et un facteur de puissance.

La figure 8 représente un schéma bloc d'un récepteur de message selon d'un dispositif selon un mode de réalisation de l'invention. Les messages sont reçus par un récepteur 50 et un module 51 de traitement des messages reçus. Un module 52 connecté au module 51 assure la correction des valeurs d'énergie reçues. Des erreurs de mesure d'énergie peuvent être dues à des non-linéarités du capteur à bas niveau de courant à cause de la magnétisation du circuit magnétique, à des fuites de courant dans les composants, à haut niveau à cause de la saturation du circuit magnétique, et/ou au temps de traitement et d'émission et de décharge lorsque pour de forts courants ce temps n'est plus négligeable par rapport au temps de charge du condensateur 9. Ces erreurs sont connues ou mesurables lors de paramétrages, elles peuvent alors être corrigées dans des récepteurs par des coefficients ou des tables de correction dans un module 52. Un module 53 traite les valeurs d'énergie en opérant des calculs intermédiaires des cumuls ou en extraction de puissance Selon les messages il incrémente un compteur d'énergie électrique. Un module 54 reçoit un signal de tension V et la synchronisation de l'arrivée d'un message depuis le module 51. Il détermine la valeur de la tension V pour le calcul de l'énergie et de la puissance, et un décalage entre un passage à zéro de la tension V et le signal de réception de message représentatif un passage à zéro du courant Is. Ce décalage servira à déterminer un déphasage entre la tension et le courant et un facteur de puissance. Ces valeurs sont données au module 53 qui complète les calculs de puissance réelle ou réactive. Le module 53 peut mémoriser les valeurs d'énergie dans un module 55 de stockage de données, de les communiquer à travers un circuit de communication 56, ou de les afficher sur un écran 57. Un module 58 élabore un signal en retour pour certains émetteurs dans le but d'affiner ou modifier le paramétrage. Les messages en retour comportent notamment des valeurs d'une nouvelle unité d'énergie, des valeurs de déphasage ou de facteur de puissance, des valeurs de tension dans le cas où l'unité d'énergie peut être calculée localement par l'émetteur, et/ou des valeurs de nombre N pour déterminer le nombre de charges et décharges avant émission d'un signal.

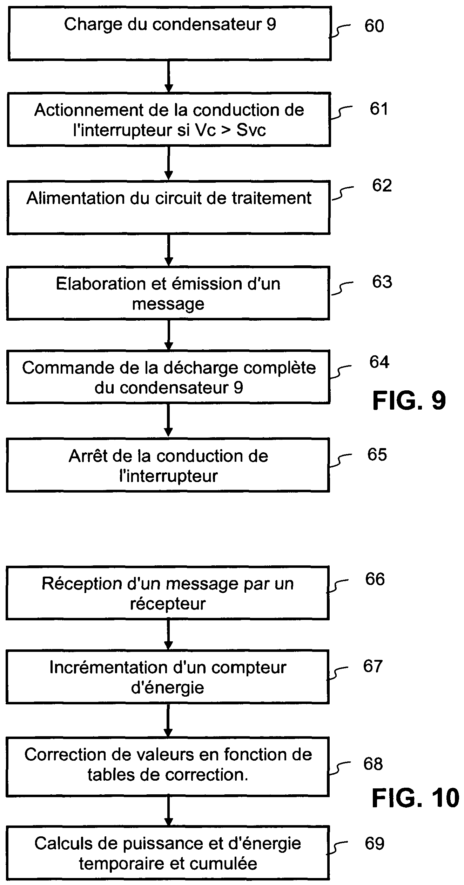

Les figures 9 et 10 représentent un premier organigramme d'un procédé selon un mode de réalisation de l'invention. La charge d'un condensateur 9 avec un courant secondaire représentatif d'un courant circulant dans un conducteur électrique est réalisée à une étape 60. Lorsque la tension du condensateur dépasse un seuil prédéterminé Svc, la conduction d'un interrupteur est actionnée a une étape 61. L'alimentation d'un circuit de traitement par la charge du condensateur à travers ledit interrupteur est réalisée à l'étape 62. Puis à une étape 63, il y a l'élaboration et l'émission d'un message d'énergie représentatif d'une quantité d'énergie électrique ou d'une intégration de courant ayant circulé dans ledit conducteur électrique primaire. Puis, en fin d'émission de message, une étape 64 commande une décharge complète du condensateur et une étape 65 commande l'arrêt de la conduction dudit interrupteur.

Sur la figure 10, une étape 66 permet la réception dudit message représentatif d'une quantité d'énergie électrique par un récepteur. Dans le récepteur, une étape 67 opère l'incrémentation d'un compteur d'énergie électrique. A une étape 68 il y a la correction de valeurs ou de quantités d'énergie électrique pour corriger une non linéarité dudit capteur de courant sur la plage de fonctionnement, des erreurs dues à des courant de fuite de composant et/ou des erreurs dues à des temps de traitement et de transmission. Une étape 69 permet de calculer des valeurs de puissance ou énergie temporaire ou cumulée.

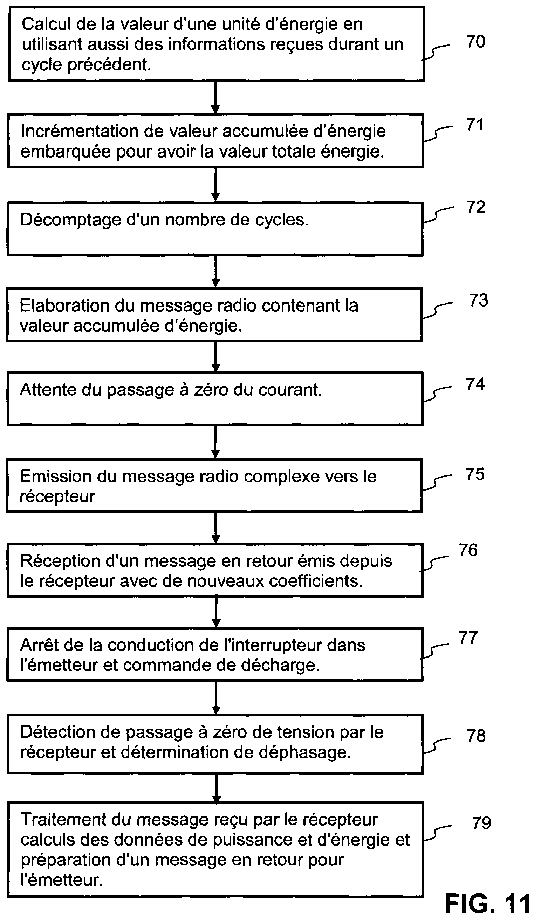

La figure 11 représente un second organigramme d'un procédé selon un mode réalisation de l'invention. Les étapes de ce procédé sont supplémentaires ou intégrées à des étapes des organigrammes des figures 9 et 10. A une étape 70, dès que le seuil de tension est dépassé et que le circuit de traitement est alimenté, un calcul d'une unité d'énergie est réalisé en fonction d'une constante dépendant du cycle de charge du condensateur et d'informations reçues durant un cycle précédent. Ces informations sont notamment la valeur de la tension électrique du réseau, la valeur du déphasage ou du facteur de puissance entre le courant et la tension électrique, ou une valeur d'unité d'énergie électrique. A une étape 71, une valeur d'énergie accumulée embarquée est incrémentée avec la nouvelle valeur calculée à l'étape 70 pour avoir une valeur totale d'énergie. Une étape 72 attend ou compte un nombre prédéterminé N de cycle de charges et décharges dudit condensateur 9 avant l'émission de messages d'énergie. La quantité d'énergie électrique est alors proportionnelle audit nombre prédéterminé de cycles ou cumulée pendant ce nombre de cycle si les valeurs sont complexes et différentes à chaque cycle. A une étape 73, il y a l'élaboration d'un message représentatif d'une quantité d'énergie électrique avec des données complètes de valeur d'énergie électrique. L'attente d'un passage à zéro dudit courant secondaire pour émettre ledit message représentatif d'une quantité d'énergie électrique est réalisée à une étape 74. Cette attente permet à un récepteur de calculer des décalages de passages à zéro entre le courant et la tension d'un réseau lors de la réception d'un message. Ainsi, à une étape 75, il y a l'émission d'un message complexe pouvant comporter une valeur d'énergie instantanée ou temporaire une valeur d'énergie cumulée entre deux émission ou une valeur d'énergie totale. Après l'émission d'un message d'énergie, à une étape 76, il y a la réception d'un message de retour depuis un récepteur comportant des valeurs de correction et de paramétrage. Ce message de retour est préparé à l'avance par un récepteur qui le renvoie de manière reflexe après la réception d'un message d'énergie. Une étape 77 indique la fin de conduction de l'interrupteur et de la commande de décharge complète du condensateur 9.

Dans un récepteur, il y a une étape 78 pour la détection d'un instant de passage à zéro d'une tension électrique d'un réseau. Puis une valeur représentative d'un déphasage entre une tension et un courant en fonction de l'instant de passage à zéro de la dite tension électrique et de l'instant de réception dudit message d'énergie est déterminée par ledit récepteur. A une étape 79, le message d'énergie reçu est traité pour le calcul de données d'énergie, de puissance, ou de valeur moyenne de courant. Ces données peuvent être par exemple stockées, communiquées, affichées, ou traitées pour d'autres fonctions de gestion d'énergie électrique. A l'étape 79, le message de retour est préparé pour être renvoyé en réponse à une prochaine réception d'un message d'énergie. Par exemple, le message en retour reçu à l'étape 76 et émis depuis un récepteur comporte des données représentatives d'un déphasage entre une tension et un courant, une valeur de tension électrique, un nombre N de cycles de charge-décharge avant émission de message, des paramètres de correction et/ou une valeur d'énergie électrique corrigée.

Les liaisons entre les émetteurs décrits ci-dessus sont de préférence des liaisons radio sans fils dans lesquels les émetteurs radio sont autonomes en énergie. Ces liaisons peuvent aussi être optiques notamment avec des émetteurs et des récepteurs infrarouges. Les messages peuvent aussi être envoyés sur une liaison filaire dans laquelle l'émetteur a une auto alimentation par le capteur de courant.

La liaison radio sans fils utilisée entre l'émetteur et le récepteur est de préférence réalisée selon la technologie dite "ZigBee" de l'association "ZigBee Alliance". Le capteur de courant 2 est de préférence un transformateur de courant de type tore fermé ou de type à circuit magnétique ouvrant pour une installation facile sur des conducteurs électriques. Le condensateur 9 est avantageusement de très forte valeur par exemple entre 500 et 1000 microfarads avec un courant de fuite très faible. Le circuit 12 de détection de seuil de tension est un circuit à très faible courant de fuite, son seuil tension est de préférence entre 3 et 5 volts pour avoir une faible charge sur le capteur. Les diodes 8 sont de préférence des diodes de type Schottky à basse tension directe.

Les messages d'énergie envoyés par le dispositif peuvent être de plusieurs types ils peuvent comprendre notamment de simples identifiants, et/ou des identifiants avec des compteurs qui incrémentent à chaque émission de messages, et/ou des messages avec une valeur d'énergie unitaire, et/ou des messages avec une valeur d'énergie corrigée localement, et/ou des messages avec des valeurs de cumul d'énergie.

**Revendications**

1. Dispositif de comptage d'énergie électrique comportant :

   - au moins un capteur (2) de courant pour fournir un courant (Is) secondaire de mesure représentatif d'un courant (Ip) primaire circulant dans un conducteur (3) électrique primaire,
   - un circuit électronique (7) de mesure et de redressement connecté audit au moins un capteur (2) de courant,
   - un circuit (10) de traitement connecté au circuit électronique (8) de mesure et de redressement,
   - un émetteur (11) connecté au circuit de traitement pour émettre des messages dans un réseau de communication sans fils vers un récepteur (5) de mesure d'énergie électrique,
   - un condensateur (9) d'intégration de courant électrique connecté audit au moins un capteur (2) de courant à travers des moyens (8) de redressement de courant,
   - des moyens de détection (12) à seuil de tension connectés audit condensateur (9) d'intégration pour détecter un dépassement d'un seuil de tension prédéterminé (Svc) sur ledit condensateur (9) d'intégration,
   - des moyens interrupteurs (13) commandés par lesdits moyens de détection (12) de seuil pour déclencher l'alimentation électrique dudit circuit de traitement (10) et dudit émetteur (11) avec une énergie accumulée dans le condensateur d'intégration lorsqu'une tension électrique (Vc) sur ledit condensateur d'intégration a dépassé ledit seuil de tension prédéterminé (Svc), ledit circuit de traitement (10) et ledit émetteur (11) émettant alors un message d'énergie,

   dispositif **caractérisé en ce que** :

   - le circuit de traitement est agencé pour incrémenter une valeur d'énergie accumulée avec une unité d'énergie calculée en fonction d'une constante dépendant du cycle de charge dudit condensateur en vue d'obtenir une valeur totale d'énergie électrique,
   - ledit message d'énergie est d'énergie électrique calculée, et

   - **en ce que** le dispositif comporte des moyens de décharge (15, 16, 20-24) pour décharger ledit condensateur d'intégration (9) en fin de cycle d'émission.

2. Dispositif selon la revendication 1 **caractérisé en ce que** lesdits moyens interrupteurs (13) sont composés d'un composant de type thyristor arrêtant de conduire au dessous d'un courant de maintien, et les moyens de détection (12) sont dans un composant à référence de tension à faible courant de fuite en entrée.

3. Dispositif selon l'une quelconque des revendications 1 à 2 **caractérisé en ce qu'**il comporte des moyens de détection (17) d'un passage à zéro du courant, ledit message d'énergie étant émis lorsqu'un passage à zéro est détecté.

4. Dispositif selon l'une quelconque des revendications 1 à 3 **caractérisé en ce que** le circuit de traitement (10) comporte des moyens (70) de correction pour corriger localement des valeurs des données d'énergie en fonction de paramètres pré-chargés ou envoyés par des messages précédents en retour.

5. Dispositif selon l'une quelconque des revendications 1 à 4 **caractérisé en ce qu'**il comporte des moyens (10, 53) de calcul d'une valeur moyenne dudit courant primaire (Ip) disposés dans ledit circuit de traitement (10) et/ou dans un module (53) de traitement d'un récepteur.

6. Procédé de comptage d'énergie électrique **caractérisé en ce qu'**il comporte :

   - la charge (60) d'un condensateur d'intégration (9) avec un courant secondaire représentatif d'un courant circulant dans un conducteur électrique (3),
   - l'incrémentation d'une valeur d'énergie accumulée avec une unité d'énergie calculée en fonction d'une constante dépendant du cycle de charge dudit condensateur en vue d'obtenir une valeur totale d'énergie électrique,
   - l'actionnement (61) de la conduction d'un interrupteur (13) lorsqu'une tension dudit condensateur d'intégration (9) dépasse un seuil prédéterminé (Svc),
   - l'alimentation (62) d'un circuit de traitement par une tension de charge dudit condensateur d'intégration (9) à travers ledit interrupteur (13),
   - l'élaboration et l'émission (63) d'un message d'énergie représentatif de la valeur totale d'énergie électrique calculée,
   - la commande (64) d'une décharge complète du condensateur, et
   - l'arrêt (65) de la conduction dudit interrupteur.

**7.** Procédé de comptage selon la revendication 6 **caractérisé en ce qu'**il comporte

> - la réception (66) par un récepteur dudit message représentatif de la valeur totale d'énergie électrique calculée.,

**8.** Procédé de comptage selon l'une des revendications 6 ou 7 **caractérisé en ce qu'**il comporte :

> - la réception (76) d'un message de retour depuis un récepteur comportant des valeurs de correction et de paramétrage, et
> - l'élaboration et l'émission (70, 73, 75) dudit message d'énergie représentatif de la valeur totale d'énergie électrique.

**9.** Procédé de comptage selon l'une des quelconque des revendications 6 à 8 **caractérisé en ce qu'**il comporte :

> - l'attente (74) d'un passage à zéro dudit courant secondaire pour émettre ledit message représentatif la valeur totale d'énergie électrique,
> - la détection (78) d'un instant de passage à zéro d'une tension électrique par un récepteur, et
> - la détermination (78) par ledit récepteur d'une valeur représentative d'un déphasage entre une tension et un courant en fonction de l'instant de passage à zéro de la dite tension électrique et de l'instant de réception dudit message d'énergie.

**10.** Procédé de comptage selon l'une des quelconque des revendications 6 à 9 **caractérisé en ce que** l'émission (75) des messages d'énergie est effectuée lorsque plusieurs cycles de charge et décharge dudit condensateur sont réalisés.

**11.** Procédé de comptage selon l'une quelconque des revendications 6 à 10 **caractérisé en ce qu'**il comporte la correction (68) de valeurs ou de quantités d'énergie électrique pour corriger une non linéarité dudit capteur de courant sur la plage de fonctionnement, des erreurs dues à des courant de fuite de composant et/ou des erreurs dues à des temps de traitement et de transmission.

**12.** Procédé de comptage selon l'une des quelconque des revendications 6 à 11 **caractérisé en ce qu'**il comporte l'émission (76) d'un message en retour (31) depuis un récepteur de message d'énergie, ledit message de retour comportant des données représentatives d'un déphasage ($\varphi$, 36) entre une tension et un courant, d'une valeur de tension électrique (V, 37), d'un nombre (N, 35) de cycles de charge-décharge avant émission de message, de paramètres (38) de correction et/ou une valeur d'énergie électrique corrigée.

**Patentansprüche**

**1.** Einrichtung zum Zählen elektrischer Energie, umfassend:

> - mindestens einen Stromfühler (2), um einen Sekundärmessstrom (Is) zu liefern, der für einen Primärstrom (Ip), der in einem primären elektrischen Leiter (3) zirkuliert, repräsentativ ist,
> - eine elektronische Mess- und Gleichrichterschaltung (7), die an den mindestens einen Stromfühler (2) angeschlossen ist,
> - eine Bearbeitungsschaltung (10), die an die elektronische Mess- und Gleichrichterschaltung (8) angeschlossen ist,
> - einen Sender (11), der an die Bearbeitungsschaltung angeschlossen ist, um Nachrichten in ein drahtloses Kommunikationsnetz zu einem Empfänger (5) zum Messen von elektrischer Energie zu senden,
> - einen Kondensator (9) zur Integration von elektrischem Strom, der an den mindestens einen Stromfühler (2) über Stromgleichrichtermittel (8) angeschlossen ist,
> - Erfassungsmittel (12) mit Spannungsgrenze, die an den Kondensator (9) zur Integration angeschlossen sind, um eine Überschreitung einer vorbestimmten Spannungsgrenze (Svc) auf dem Kondensator (9) zur Integration zu erfassen,
> - Unterbrechungsmittel (13), die von den Mitteln zur Erfassung (12) einer Grenze gesteuert werden, um die elektrische Versorgung der Bearbeitungsschaltung (10) und des Senders (11) mit einer in dem Integrationskondensator gespeicherten Energie auszulösen, wenn eine elektrische Spannung (Vc) auf dem Integrationskondensator die vorbestimmte Spannungsgrenze (Svc) überschritten hat, wobei die Bearbeitungsschaltung (10) und der Sender (11) nun eine Energienachricht entsenden,

wobei die Einrichtung **dadurch gekennzeichnet ist, dass**:

> - die Bearbeitungsschaltung dazu vorgesehen ist, einen Wert von gespeicherter Energie mit einer Energieeinheit, die in Abhängigkeit von einer Konstante, die vom Ladezyklus des Kondensators abhängt, berechnet ist, zu inkrementieren, um einen Gesamtwert von elektrischer Energie zu erhalten,
> - wobei die Energienachricht für den berechneten Gesamtwert von elektrischer Energie repräsentativ ist, und

- dass die Einrichtung Entlademittel (15, 16, 20-24) umfasst, um den Integrationskondensator (9) am Ende des Sendezyklus zu entladen.

2. Einrichtung nach Anspruch 1, **dadurch gekennzeichnet, dass** die Unterbrechungsmittel (13) aus einer Komponente vom Typ Thyristor bestehen, der unter einem Haltestrom aufhört zu leiten, und die Erfassungsmittel (12) in einer Komponente mit Spannungsreferenz mit geringem Leckagestrom am Eingang bestehen.

3. Einrichtung nach einem der Ansprüche 1 bis 2, **dadurch gekennzeichnet, dass** sie Mittel (17) zur Erfassung eines Nulldurchgangs des Stroms umfasst, wobei die Energienachricht gesandt wird, wenn ein Nulldurchgang erfasst wird.

4. Einrichtung nach einem der Ansprüche 1 bis 3, **dadurch gekennzeichnet, dass** die Bearbeitungsschaltung (10) Korrekturmittel (70) umfasst, um lokal Werte der Energiedaten in Abhängigkeit von vorgeladenen oder durch vorhergehende Nachrichten zurück gesandten Parametern zu korrigieren.

5. Einrichtung nach einem der Ansprüche 1 bis 4, **dadurch gekennzeichnet, dass** sie Mittel (10, 53) zur Berechnung eines durchschnittlichen Werts des Primärstroms (Ip) umfasst, die in der Bearbeitungsschaltung (10) und/oder in einem Bearbeitungsmodul (53) eines Empfängers angeordnet sind.

6. Verfahren zum Zählen elektrischer Energie, **dadurch gekennzeichnet, dass** es umfasst:

   - das Laden (60) eines Integrationskondensators (9) mit einem Sekundärstrom, der für einen in einem elektrischen Leiter (3) zirkulierenden Strom repräsentativ ist,
   - das Inkrementieren eines gespeicherten Energiewerts mit einer Energieeinheit, die in Abhängigkeit von einer Konstante, die von dem Ladezyklus des Kondensators abhängt, berechnet wird, um einen Gesamtwert von elektrischer Energie zu erhalten,
   - die Betätigung (61) der Leitung eines Schalters (13), wenn eine Spannung des Integrationskondensators (9) eine vorbestimmte Grenze (Svc) überschreitet,
   - die Versorgung (62) einer Bearbeitungsschaltung mit einer Ladespannung des Integrationskondensators (9) durch den Schalter (13),
   - das Ausarbeiten und Senden (63) einer Energienachricht, die für den berechneten Gesamtwert an elektrischer Energie repräsentativ ist,
   - die Steuerung (64) einer vollständigen Entladung des Kondensators, und
   - das Einstellen (65) der Leitung des Schalters.

7. Zählverfahren nach Anspruch 6, **dadurch gekennzeichnet, dass** es umfasst:

   - den Empfang (66) der Nachricht, die für den berechneten Gesamtwert von elektrischer Energie repräsentativ ist, durch einen Empfänger.

8. Zählverfahren nach einem der Ansprüche 6 oder 7, **dadurch gekennzeichnet, dass** es umfasst:

   - den Empfang (76) einer Rücknachricht von einem Empfänger, umfassend Korrektur- und Parametrierungswerte, und
   - das Ausarbeiten und Senden (70, 73, 75) der Energienachricht, die für den Gesamtwert von elektrischer Energie repräsentativ ist.

9. Zählverfahren nach einem der Ansprüche 6 bis 8, **dadurch gekennzeichnet, dass** es umfasst:

   - das Warten (74) auf einen Nulldurchgang des Sekundärstroms, um die für den Gesamtwert von elektrischer Energie repräsentative Nachricht zu senden,
   - die Erfassung (78) eines Nulldurchgangszeitpunkts einer elektrischen Spannung durch einen Empfänger, und
   - die Bestimmung (78) eines Werts durch den Empfänger, der für eine Phasenverschiebung zwischen einer Spannung und einem Strom in Abhängigkeit von dem Nulldurchgangszeitpunkt der elektrischen Spannung und dem Empfangszeitpunkt der Energienachricht repräsentativ ist.

10. Zählverfahren nach einem der Ansprüche 6 bis 9, **dadurch gekennzeichnet, dass** das Senden (75) der Energienachrichten erfolgt, wenn mehrere Lade- und Entladezyklen des Kondensators durchgeführt sind.

11. Zählverfahren nach einem der Ansprüche 6 bis 10, **dadurch gekennzeichnet, dass** es die Korrektur (68) von Werten und Mengen von elektrischer Energie umfasst, um eine Nicht-Linearität des Stromfühlers in dem Funktionsbereich, Fehler auf Grund der Leckageströme einer Komponente und/oder Fehler auf Grund der Bearbeitungs- und Übertragungszeiten zu korrigieren.

12. Zählverfahren nach einem der Ansprüche 6 bis 11, **dadurch gekennzeichnet, dass** es das Senden (76) einer Rücknachricht (31) von einem Empfänger einer Energienachricht umfasst, wobei die Rücknachricht Daten umfasst, die für eine Phasenverschiebung ($\varphi$, 36) zwischen einer Spannung und einem Strom, einen Wert einer elektrischen Spannung (V, 37), eine Anzahl (N, 35) von Lade-Entlade-Zyklen vor dem Senden einer Nachricht, Korrekturparameter (38) und/oder einen korrigierten elektrischen Energiewert repräsentativ sind.

## Claims

1. Device for metering electric power, comprising:

    - at least one current sensor (2) for supplying a secondary measurement current (Is) representative of a primary current (Ip) flowing in a primary electrical conductor (3),
    - an electronic measurement and rectification circuit (7) connected to said at least one current sensor (2),
    - a processing circuit (10) connected to the electronic measurement and rectification circuit (8),
    - a transmitter (11), connected to the processing circuit, for transmitting messages in a wireless communications network to an electric power measurement receiver (5),
    - an electric current integrating capacitor (9) connected to said at least one current sensor (2) via current rectification means (8),
    - voltage threshold detection means (12), connected to said integrating capacitor (9), for detecting the exceedance of a predetermined voltage threshold (Svc) across said integrating capacitor (9),
    - switching means (13), controlled by said threshold detection means (12), for triggering the supply of electric power to said processing circuit (10) and said transmitter (11) with energy accumulated in the integrating capacitor when a voltage (Vc) across said integrating capacitor has exceeded said predetermined voltage threshold (Svc), said processing circuit (10) and said transmitter (11) then transmitting a power message,

    the device being **characterized in that**

    - the processing circuit is designed to increment an accumulated power value by one unit of power calculated as a function of a constant dependent on the charge cycle of said capacitor, with a view to obtaining a total value of electric power,
    - said power message is representative of the total calculated value of electric power, and
    - **in that** the device comprises discharging means (15, 16, 20-24) for discharging said integrating capacitor (9) at the end of the transmission cycle.

2. Device according to Claim 1, **characterized in that** said switching means (13) consist of a thyristor-type component that stops conducting below a holding current, and the detection means (12) are in a voltage reference component with a low input leakage current.

3. Device according to either of Claims 1 and 2, **characterized in that** it comprises means (17) for detecting a current zero crossing, said power message being transmitted when a zero crossing is detected.

4. Device according to any one of Claims 1 to 3, **characterized in that** the processing circuit (10) comprises correcting means (70) for locally correcting values of the power data as a function of settings that are preloaded or sent via returning preceding messages.

5. Device according to any one of Claims 1 to 4, **characterized in that** it comprises means (10, 53) for calculating an average value of said primary current (Ip) that are arranged in said processing circuit (10) and/or in a processing module (53) of a receiver.

6. Method for metering electric power, **characterized in that** it comprises:

    - charging (60) an integrating capacitor (9) with a secondary current representative of a current flowing in an electrical conductor (3),
    - incrementing an accumulated power value by one unit of power calculated as a function of a constant dependent on the charge cycle of said capacitor, with a view to obtaining a total value of electric power,
    - activating (61) the conduction of a switch (13) when a voltage across said integrating capacitor (9) exceeds a predetermined threshold (Svc),
    - supplying power (62) to a processing circuit by means of a charging voltage across said integrating capacitor (9) through said switch (13),
    - preparing and transmitting (63) a power message representative of the total calculated value of electric power,
    - controlling (64) complete discharge of the capacitor, and
    - stopping (65) the conduction of said switch.

7. Metering method according to Claim 6, **characterized in that** it comprises

    - receiving (66), by means of a receiver, said message representative of the total calculated value of electric power.

8. Metering method according to either of Claims 6 and 7, **characterized in that** it comprises:

    - receiving (76), from a receiver, a return message containing correction and setting values, and

- preparing and transmitting (70, 73, 75) said power message representative of the total value of electric power.

9. Metering method according to any one of Claims 6 to 8, **characterized in that** it comprises:

- waiting (74) for a zero crossing of said secondary current in order to transmit said message representative of the total value of electric power,
- detecting (78), by means of a receiver, a time of a zero crossing of a voltage, and
- determining (78), by means of said receiver, a value representative of a phase shift between a voltage and a current as a function of the time of the zero crossing of said voltage and the time of receipt of said power message.

10. Metering method according to any one of Claims 6 to 9, **characterized in that** the power messages are transmitted (75) when a plurality of charge and discharge cycles of said capacitor take place.

11. Metering method according to any one of Claims 6 to 10, **characterized in that** it comprises correcting (68) values or quantities of electric power in order to correct nonlinearity of said current sensor in the operating range, errors caused by component leakage currents and/or errors caused by processing and transmission times.

12. Metering method according to any one of Claims 6 to 11, **characterized in that** it comprises transmitting (76) a return message (31) from a power message receiver, said return message containing data representative of a phase shift ($\varphi$, 36) between a voltage and a current, a voltage value (V, 37), a number (N, 35) of charge-discharge cycles prior to message transmission, correction settings (38) and/or a corrected value of electric power.

**FIG. 1**

**FIG. 2**

**FIG. 3**

**FIG. 4A**

**FIG. 4B**

26      27      28      25      29      30

| Pr. | Sync | ID Source | Compteur Imp. ou Compteur d'Energie. | Fin |
|-----|------|-----------|--------------------------------------|-----|

**FIG. 5A**

32    33    34    35    31    36    37    38    39

| Pr. | Sync | ID Cible | N | Cos(φ) | Tension Secteur | Coef Corr | Fin |
|-----|------|----------|---|--------|-----------------|-----------|-----|

**FIG. 5B**

T

**FIG. 6A** V

Vc

Svc

t1        t2    t

**FIG. 6B** 1 / 0

40

t

**FIG. 6C** 1 / 0

41

t3    t4

t

**FIG. 6D** 1 / 0

42

t5

t

**FIG. 7A**

**FIG. 7B**

**FIG. 7C**

**FIG. 8**

| Charge du condensateur 9 | 60 |

↓

| Actionnement de la conduction de l'interrupteur si Vc > Svc | 61 |

↓

| Alimentation du circuit de traitement | 62 |

↓

| Elaboration et émission d'un message | 63 |

↓

| Commande de la décharge complète du condensateur 9 | 64 |

**FIG. 9**

↓

| Arrêt de la conduction de l'interrupteur | 65 |

| Réception d'un message par un récepteur | 66 |

↓

| Incrémentation d'un compteur d'énergie | 67 |

↓

| Correction de valeurs en fonction de tables de correction. | 68 |

**FIG. 10**

↓

| Calculs de puissance et d'énergie temporaire et cumulée | 69 |

Calcul de la valeur d'une unité d'énergie en utilisant aussi des informations reçues durant un cycle précédent. ⟋ 70

Incrémentation de valeur accumulée d'énergie embarquée pour avoir la valeur totale énergie. ⟋ 71

Décomptage d'un nombre de cycles. ⟋ 72

Elaboration du message radio contenant la valeur accumulée d'énergie. ⟋ 73

Attente du passage à zéro du courant. ⟋ 74

Emission du message radio complexe vers le récepteur ⟋ 75

Réception d'un message en retour émis depuis le récepteur avec de nouveaux coefficients. ⟋ 76

Arrêt de la conduction de l'interrupteur dans l'émetteur et commande de décharge. ⟋ 77

Détection de passage à zéro de tension par le récepteur et détermination de déphasage. ⟋ 78

Traitement du message reçu par le récepteur calculs des données de puissance et d'énergie et préparation d'un message en retour pour l'émetteur. ⟋ 79

**FIG. 11**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2008142429 A
- EP 2048482 A
- JP 56063264 B
- JP 2042367 A
- JP 56029471 B